# FASCICULE DE BREVET EUROPEEN

(11) **EP 2 839 054 B1**
(45) Date de publication et mention de la délivrance du brevet: **21.06.2017**
(21) Numéro de dépôt: 13720487.1
(22) Date de dépôt: 15.04.2013
(51) Int. Cl.: C23C 14/58, C03C 17/00, B23K 26/08, H01B 13/00, B23K 26/00, C03C 17/36, H01B 5/14

(54) **PROCEDE D'OBTENTION D'UN SUBSTRAT REVETU**
VERFAHREN ZUR HERSTELLUNG EINES BESCHICHTETEN SUBSTRATS
METHOD FOR PRODUCING A COATED SUBSTRATE

(30) Priorité: 17.04.2012 FR 1253524
(43) Date de publication de la demande: 25.02.2015
(73) Titulaire: Saint-Gobain Glass France, 92400 Courbevoie (FR)
(72) Inventeur: MIMOUN, Emmanuel, F-75016 Paris (FR); BILAINE, Matthieu, F-75015 Paris (FR)
(74) Mandataire: Saint-Gobain Recherche
(86) Numéro de dépôt international: PCT/FR2013/050813
(87) Numéro de publication internationale: WO 2013/156721

(56) Documents cités:
- WO-A1-2010/115558
- WO-A1-2010/142926
- WO-A1-2011/039488

## Description

L'invention se rapporte au traitement thermique de substrats munis de revêtements à l'aide d'un rayonnement laser.

Il est connu dans le domaine de la microélectronique de traiter thermiquement des revêtements (par exemple en silicium) déposés sur des substrats à l'aide de lignes laser focalisées, typiquement des lasers excimères émettant dans l'ultraviolet. Ces procédés sont couramment employés pour obtenir du silicium polycristallin à partir de silicium amorphe, par fusion locale du silicium et recristallisation au refroidissement. Traditionnellement, l'excellente planéité des substrats utilisés en microélectronique, leur faible taille, et l'environnement industriel typique dans ce type d'industrie permettent de positionner très précisément le substrat au foyer du laser afin de traiter de manière homogène et optimale la totalité du substrat. Les faibles vitesses de traitement autorisent l'emploi, pour le déplacement des substrats, de systèmes tabulaires sur coussin d'air. Si besoin, des systèmes permettant d'asservir la position du substrat par rapport au foyer du laser peuvent corriger d'éventuels défaut de planéité ou la présence de vibrations à basse fréquence. Les systèmes d'asservissement sont compatibles avec les faibles vitesses de traitement employées.

Les traitements laser sont maintenant mis en oeuvre pour traiter thermiquement des couches sur verre ou substrat organique polymérique pour des applications industrielles différentes : on peut citer à titre d'exemples la production de vitrages autonettoyants comprenant des revêtements à base de TiO₂, la production de vitrages bas-émissifs contenant un substrat de verre revêtu d'un empilement comprenant au moins une couche d'argent, décrite dans la demande WO2010/142926, ou la production de substrats de grande taille pour cellules photovoltaïques comprenant des couches minces conductrices et transparentes (TCO), décrite dans la demande WO2010/139908.

Le contexte industriel et économique est ici totalement différent. Typiquement, les substrats à traiter peuvent être de très grandes feuilles de verre dont la surface est de l'ordre de 6*3 m², donc dont la planéité ne peut être contrôlée de manière précise (par exemple à moins de +/- 1 mm), déplacées à grande vitesse (parfois de l'ordre de 10 m/minute ou plus) sur des convoyeurs industriels à la sortie de machines de dépôt (par exemple par pulvérisation cathodique), donc dans un environnement industriel générant des vibrations pouvant être importantes. De ce fait, la position de chaque point du revêtement à traiter par rapport au plan focal du laser peut varier de manière importante, entraînant de fortes hétérogénéités de traitement. Les grandes vitesses de déplacement des substrats rendent extrêmement délicates voire impossibles la mise en place de systèmes d'asservissement mécanique de la position du substrat.

Il existe donc un besoin de proposer un procédé de traitement laser permettant de traiter économiquement, de manière homogène et à grande vitesse des substrats présentant des défauts de planéité dans un environnement industriel difficile.

A cet effet, l'invention a pour objet un procédé d'obtention d'un substrat en verre ou un substrat organique polymérique muni sur au moins une partie d'au moins une de ses faces d'un revêtement, comprenant une étape de dépôt dudit revêtement sur ledit substrat, puis une étape de traitement thermique dudit revêtement au moyen d'un rayonnement laser pulsé ou continu focalisé sur ledit revêtement sous la forme d'au moins une ligne laser, dont la longueur d'onde est comprise dans un domaine allant de 400 à 1500 nm, ledit traitement thermique étant tel que l'on crée un mouvement de déplacement relatif entre le substrat et la ou chaque ligne laser dont la vitesse est d'au moins 3 mètres par minute, la ou chaque ligne laser présentant un facteur de qualité du faisceau (BPP) d'au plus 3 mm.mrad et, mesurées à l'endroit où la ou chaque ligne laser est focalisée sur ledit revêtement, une puissance linéique divisée par la racine carrée du rapport cyclique d'au moins 200 W/cm, une longueur d'au moins 20 mm et une distribution de largeurs le long de la ou chaque ligne telle que la largeur moyenne est d'au moins 30 micromètres et la différence entre la largeur la plus grande et la largeur la plus petite vaut au plus 15% de la valeur de la largeur moyenne.

L'invention a également pour objet un dispositif de traitement thermique d'un revêtement déposé sur un substrat, au moyen d'un rayonnement laser pulsé ou continu dont la longueur d'onde est comprise dans un domaine allant de 400 à 1500 nm, focalisé sur ledit revêtement sous la forme d'au moins une ligne, comprenant :
- une ou plusieurs sources laser ainsi que des optiques de mise en forme et de redirection capables de générer au moins une ligne laser susceptible de présenter en fonctionnement un facteur de qualité du faisceau (BPP) d'au plus 3 mm.mrad et, mesurées à l'endroit où la ou chaque ligne laser est focalisée sur ledit revêtement, une puissance linéique divisée par la racine carrée du rapport cyclique d'au moins 200 W/cm, une longueur d'au moins 20 mm et une distribution de largeurs le long de la ou chaque ligne telle que la largeur moyenne est d'au moins 30 micromètres et la différence entre la largeur la plus grande et la largeur la plus petite vaut au plus 15% de la valeur de la largeur moyenne, et
- des moyens de déplacement aptes à créer en fonctionnement un mouvement de déplacement relatif entre le substrat et la ou chaque ligne laser dont la vitesse est d'au moins 3 mètres par minute.

Les inventeurs ont pu mettre en évidence que le choix combiné d'une longueur d'onde, d'un facteur de qualité du faisceau, d'une puissance linéique et d'une largeur de ligne laser adéquates permettait de traiter les substrats de manière homogène, en tolérant de grandes variations de distance par rapport au foyer du laser. On entend par traitement homogène un traitement tel que la température atteinte en chaque point lors du traitement ne varie pas de plus de 15%, notamment 10%, voire 5% en relatif par rapport à la température visée. De la sorte, les propriétés obtenues (résistivité, émissivité, activité photocatalytique, aspect visuel en réflexion ou absorption, selon le type de couches traitées) sont remarquablement homogènes sur toute la surface du substrat. Avantageusement, et grâce au choix susmentionné, la largeur de la ou chaque ligne laser et/ou la température atteinte par le revêtement varie d'au plus 10% en relatif lorsque la distance du revêtement au plan focal du laser varie de +/-1 mm.

De préférence, le substrat, qui est généralement sensiblement horizontal, se déplace sur un convoyeur en regard de la ou chaque ligne laser, la ou chaque ligne laser étant fixe et disposée sensiblement perpendiculairement à la direction du déplacement. La ou chaque ligne laser peut être disposée au-dessus et/ou en-dessous du substrat.

D'autres modes de réalisation sont bien entendu possibles. Par exemple, le substrat peut être fixe, la ou chaque ligne laser étant déplacée en regard du substrat, notamment à l'aide d'un portique mobile. La ou chaque ligne laser peut aussi ne pas être disposée perpendiculairement à la direction de déplacement, mais en biais, selon tout angle possible. Le substrat peut également être déplacé sur un plan qui n'est pas horizontal, mais vertical, ou selon toute orientation possible.

Le rayonnement laser est de préférence généré par des modules comprenant une ou plusieurs sources laser ainsi que des optiques de mise en forme et de redirection.

Les sources laser sont typiquement des diodes laser ou des lasers à fibre. Les diodes laser permettent d'atteindre de manière économique de fortes densités de puissance par rapport à la puissance électrique d'alimentation pour un faible encombrement. L'encombrement des lasers à fibres est encore plus réduit, et la puissance linéique obtenue peut être encore plus élevée, pour un coût toutefois plus important.

Le rayonnement issu des sources laser peut être continu ou pulsé, de préférence continu. Comme il est d'usage, le rapport cyclique est défini comme étant le rapport entre la durée d'un pulse laser et le temps entre deux pulses successifs. Lorsque le rayonnement est continu, le rapport cyclique vaut 1, si bien que la puissance linéique divisée par la racine carrée du rapport cyclique est égale à la puissance linéique. Lorsque le rayonnement est pulsé, la fréquence de répétition est avantageusement d'au moins 10 kHz, notamment 15 kHz et même 20 kHz de manière à être compatible avec les grandes vitesses de déplacement utilisées.

La longueur d'onde du rayonnement de la ou chaque ligne laser est de préférence comprise dans un domaine allant de 800 à 1100 nm, notamment de 800 à 1000 nm. Des diodes laser de puissance émettant à une longueur d'onde choisie parmi 808 nm, 880 nm, 915 nm, 940 nm ou 980 nm se sont révélées particulièrement bien appropriées.

Les optiques de mise en forme et de redirection comprennent de préférence des lentilles et des miroirs, et sont utilisées comme moyens de positionnement, d'homogénéisation et de focalisation du rayonnement.

Les moyens de positionnement ont pour but le cas échéant de disposer selon une ligne les rayonnements émis par les sources laser. Ils comprennent de préférence des miroirs. Les moyens d'homogénéisation ont pour but de superposer les profils spatiaux des sources laser afin d'obtenir une puissance linéique homogène tout au long de la ligne. Les moyens d'homogénéisation comprennent de préférence des lentilles permettant la séparation des faisceaux incidents en faisceaux secondaires et la recombinaison desdits faisceaux secondaires en une ligne homogène. Les moyens de focalisation du rayonnement permettent de focaliser le rayonnement sur le revêtement à traiter, sous la forme d'une ligne de longueur et de largeur voulues. Les moyens de focalisation comprennent de préférence une lentille convergente.

On entend par « longueur » de la ligne la plus grande dimension de la ligne, mesurée sur la surface du revêtement, et par « largeur » la dimension selon une direction transversale à la direction de la plus grande dimension. Comme il est d'usage dans le domaine des lasers, la largeur w de la ligne correspond à la distance (selon cette direction transversale) entre l'axe du faisceau (où l'intensité du rayonnement est maximale) et le point où l'intensité du rayonnement est égale à 1/e² fois l'intensité maximale. Si l'axe longitudinal de la ligne laser est nommé x, on peut définir une distribution de largeurs selon cet axe, nommée w(x).

La largeur moyenne de la ou chaque ligne laser est de préférence d'au moins 35 micromètres, notamment comprise dans un domaine allant de 40 à 100 micromètres ou de 40 à 70 micromètres. Dans l'ensemble du présent texte on entend par « moyenne » la moyenne arithmétique. Sur toute la longueur de la ligne, la distribution de largeurs est étroite afin d'éviter toute hétérogénéité de traitement. Ainsi, la différence entre la largeur la plus grande et la largeur la plus petite vaut de préférence au plus 10% de la valeur de la largeur moyenne. Ce chiffre est de préférence d'au plus 5% et même 3%.

La longueur de la ou chaque ligne laser est de préférence d'au moins 10 cm ou 20 cm, notamment comprise dans un domaine allant de 20 ou 30 à 100 cm, notamment de 20 ou 30 à 75 cm, voire de 20 ou 30 à 60 cm.

Les optiques de mise en forme et de redirection, notamment les moyens de positionnement, peuvent être ajustées manuellement ou à l'aide d'actuateurs permettant de régler leur positionnement à distance. Ces actuateurs (typiquement des moteurs ou des cales piézoélectriques) peuvent être commandés manuellement et/ou être réglés automatiquement. Dans ce dernier cas, les actuateurs seront de préférence connectés à des détecteurs ainsi qu'à une boucle de rétroaction.

Au moins une partie des modules laser, voire leur totalité est de préférence disposée en boîte étanche, avantageusement refroidie, notamment ventilée, afin d'assurer leur stabilité thermique.

Les modules laser sont de préférence montés sur une structure rigide, appelée « pont », à base d'éléments métalliques, typiquement en aluminium. La structure ne comprend de préférence pas de plaque de marbre. Le pont est de préférence positionné de manière parallèle aux moyens de convoyage de sorte que le plan focal de la ou chaque ligne laser reste parallèle à la surface du substrat à traiter. De préférence, le pont comprend au moins quatre pieds, dont la hauteur peut être individuellement ajustée pour assurer un positionnement parallèle en toutes circonstances. L'ajustement peut être assuré par des moteurs situés au niveau de chaque pied, soit manuellement, soit automatiquement, en relation avec un capteur de distance. La hauteur du pont peut être adaptée (manuellement ou automatiquement) pour prendre en compte l'épaisseur du substrat à traiter, et s'assurer ainsi que le plan du substrat coïncide avec le plan focal de la ou chaque ligne laser.

La puissance linéique divisée par la racine carrée du rapport cyclique est de préférence d'au moins 300 W/cm, avantageusement 350 ou 400 W/cm, notamment 450 W/cm, voire 500 W/cm et même 550 W/cm. La puissance linéique divisée par la racine carrée du rapport cyclique est même avantageusement d'au moins 600 W/cm, notamment 800 W/cm, voire 1000 W/cm. Lorsque le rayonnement laser est continu, le rapport cyclique vaut 1, si bien que ce chiffre correspond à la puissance linéique. La puissance linéique est mesurée à l'endroit où la ou chaque ligne laser est focalisée sur le revêtement. Elle peut être mesurée en disposant un détecteur de puissance le long de la ligne, par exemple un puissance-mètre calorimétrique, tel que notamment le puissance-mètre Beam Finder S/N 2000716 de la société Coherent Inc. La puissance est avantageusement répartie de manière homogène sur toute la longueur de la ou chaque ligne. De préférence, la différence entre la puissance la plus élevée et la puissance la plus faible vaut moins de 10% de la puissance moyenne.

La densité d'énergie fournie au revêtement divisée par la racine carrée du rapport cyclique est de préférence d'au moins 20 J/cm², voire 30 J/cm². Ici encore, le rapport cyclique vaut 1 lorsque le rayonnement laser est continu.

Le facteur de qualité du faisceau, appelé fréquemment « beam parameter product » ou « BPP », correspond au produit de la largeur moyenne de la ligne par sa divergence. Le facteur de qualité du faisceau est de préférence d'au plus 2,6 mm.mrad, notamment 2 mm.mrad, voire 1,5 ou 1 mm.mrad. Selon certains modes de réalisation, le facteur de qualité du faisceau est d'au plus 0,7 mm.mrad, notamment 0,6 mm.mrad, et même 0,5 mm.mrad, voire 0,4 mm.mrad ou encore 0,3 mm.mrad.

Le traitement thermique selon l'invention est particulièrement bien adapté au traitement de couches faiblement absorbantes à la longueur d'onde du laser. L'absorption du revêtement à la longueur d'onde du laser est de préférence d'au moins 5%, notamment 10%. Elle est avantageusement d'au plus 90%, notamment 80% ou 70%, voire 60% ou 50%, et même 40% ou encore 30%.

La température subie par le revêtement lors du traitement thermique est de préférence d'au moins 300°C, notamment 350°C, voire 400°C.

De préférence, la température du substrat au niveau de la face opposée à la face revêtue ne dépasse pas 100°C, notamment 50°C et même 30°C pendant le traitement thermique.

Lorsque plusieurs lignes laser sont utilisées, il est préférable qu'elles soient disposées de sorte que toute la surface de l'empilement soit traitée. La ou chaque ligne est de préférence disposée perpendiculairement à la direction de défilement du substrat, ou disposée de manière oblique. Les différentes lignes peuvent traiter le substrat simultanément, ou de manière décalée dans le temps. L'important est que toute la surface à traiter le soit.

Le rayonnement laser est en partie réfléchi par le revêtement à traiter et en partie transmis au travers du substrat. Pour des raisons de sécurité, il est préférable de disposer sur le chemin de ces rayonnements réfléchis et/ou transmis des moyens d'arrêt du rayonnement. Il s'agira typiquement de boitiers métalliques refroidis par circulation de fluide, notamment d'eau. Pour éviter que le rayonnement réfléchi n'endommage les modules laser, l'axe de propagation de la ou chaque ligne laser forme un angle préférentiellement non-nul avec la normale au substrat, typiquement un angle compris entre 5 et 20°.

Afin de renforcer l'efficacité du traitement, il est préférable qu'au moins une partie du rayonnement laser (principal) transmise au travers du substrat et/ou réfléchie par le revêtement soit redirigée en direction dudit substrat pour former au moins un rayonnement laser secondaire, qui de préférence impacte le substrat au même endroit que le rayonnement laser principal, avec avantageusement la même profondeur de foyer et le même profil. La formation du ou de chaque rayonnement laser secondaire met avantageusement en oeuvre un montage optique ne comprenant que des éléments optiques choisis parmi les miroirs, les prismes et les lentilles, notamment un montage optique constitué de deux miroirs et d'une lentille, ou d'un prisme et d'une lentille. En récupérant au moins une partie du rayonnement principal perdu et en le redirigeant vers le substrat, le traitement thermique s'en trouve considérablement amélioré. Le choix d'utiliser la partie du rayonnement principal transmise au travers du substrat (mode « transmission ») ou la partie du rayonnement principal réfléchie par le revêtement (mode « réflexion »), ou éventuellement d'utiliser les deux, dépend de la nature de la couche et de la longueur d'onde du rayonnement laser.

Lorsque le substrat est en déplacement, notamment en translation, il peut être mis en mouvement à l'aide de tous moyens mécaniques de convoyage, par exemple à l'aide de bandes, de rouleaux, de plateaux en translation. Le système de convoyage permet de contrôler et réguler la vitesse du déplacement. Le moyen de convoyage comprend de préférence un châssis rigide et une pluralité de rouleaux. Le pas des rouleaux est avantageusement compris dans un domaine allant de 50 à 300 mm. Les rouleaux comprennent de préférence des bagues métalliques, typiquement en acier, recouvertes de bandages en matière plastique. Les rouleaux sont de préférence montés sur des paliers à jeu réduit, typiquement à raison de trois rouleaux par palier. Afin d'assurer une parfaite planéité du plan de convoyage, le positionnement de chacun des rouleaux est avantageusement réglable. Les rouleaux sont de préférence mus à l'aide de pignons ou de chaînes, de préférence de chaînes tangentielles, entraînés par au moins un moteur.

Les moyens de convoyage sont de préférence tels qu'au niveau de la ou chaque ligne laser, la valeur absolue de la distance entre chaque point du substrat et le plan focal de la ou chaque ligne laser est d'au plus 1 mm, notamment 0,5 mm, voire 0,3 mm et même 0,1 mm.

Si le substrat est en matière organique polymérique souple, le déplacement peut être réalisé à l'aide d'un système d'avance de films sous forme d'une succession de rouleaux. Dans ce cas, la planéité peut être assurée par un choix adéquat de la distance entre les rouleaux, en tenant compte de l'épaisseur du substrat (et donc de sa flexibilité) et de l'impact que peut avoir le traitement thermique sur la création d'une éventuelle flèche.

Lorsque la ligne laser est en déplacement, il faut prévoir un système de déplacement des modules laser (sources laser et optiques de mise en forme et de redirection), situés au-dessus ou en dessous du substrat. La durée du traitement est régulée par la vitesse de déplacement de la ligne laser. Les modules laser peuvent être déplacés, par exemple à l'aide d'un robot, dans toute direction, permettant le cas échéant un traitement de substrats courbes, comme par exemple des substrats de verre bombés.

La vitesse du mouvement de déplacement relatif entre le substrat et la ou chaque ligne laser est avantageusement d'au moins 4 m/min, notamment 5 m/min et même 6 m/min ou 7 m/min, ou encore 8 m/min et même 9 m/min ou 10 m/min. Selon certains modes de réalisation, en particulier lorsque l'absorption du revêtement à la longueur du laser est élevée ou lorsque le revêtement peut être déposé avec de grandes vitesses de dépôt, la vitesse du mouvement de déplacement relatif entre le substrat et la ou chaque ligne laser est d'au moins 12 m/min ou 15 m/min, notamment 20 m/min et même 25 ou 30 m/min. Afin d'assurer un traitement qui soit le plus homogène possible, la vitesse du mouvement de déplacement relatif entre le substrat et la ou chaque ligne laser varie lors du traitement d'au plus 10% en relatif, notamment 2% et même 1% par rapport à sa valeur nominale.

Toutes les positions relatives du substrat et du laser sont bien entendu possibles, du moment que la surface du substrat peut être convenablement irradiée. Le substrat sera le plus généralement disposé de manière horizontale ou sensiblement horizontale, mais il peut aussi être disposé verticalement, ou selon toute inclinaison possible. Lorsque le substrat est disposé horizontalement, les sources laser sont généralement disposées de manière à irradier la face supérieure du substrat. Les sources laser peuvent également irradier la face inférieure du substrat. Dans ce cas, il faut que le système de support du substrat, éventuellement le système de convoyage du substrat lorsque ce dernier est en mouvement, laisse passer le rayonnement dans la zone à irradier. C'est le cas par exemple lorsque l'on utilise des rouleaux de convoyage : les rouleaux étant disjoints, il est possible de disposer les sources laser dans une zone située entre deux rouleaux successifs.

Lorsque les deux faces du substrat sont à traiter, il est possible d'employer plusieurs sources lasers situées de part et d'autre du substrat, que ce dernier soit en position horizontale, verticale, ou selon toute inclinaison. Ces sources lasers peuvent être identiques ou différentes, en particulier leurs longueurs d'onde peuvent être différentes, notamment adaptées à chacun des revêtements à traiter. A titre d'exemple, un premier revêtement (par exemple bas-émissif) situé sur une première face du substrat peut être traité par un premier rayonnement laser émettant par exemple dans le visible ou le proche infrarouge tandis qu'un second revêtement (par exemple un revêtement photocatalytique) situé sur la deuxième face dudit substrat peut être traité par un second rayonnement laser, émettant par exemple dans l'infrarouge.

Le dispositif de traitement thermique selon l'invention peut être intégré dans une ligne de dépôt de couches, par exemple une ligne de dépôt par pulvérisation cathodique assistée par champ magnétique (procédé magnétron), ou une ligne de dépôt chimique en phase vapeur (CVD), notamment assistée par plasma (PECVD), sous vide ou sous pression atmosphérique (APPECVD). La ligne comprend en général des dispositifs de manutention des substrats, une installation de dépôt, des dispositifs de contrôle optique, des dispositifs d'empilage. Les substrats défilent, par exemple sur des rouleaux convoyeurs, successivement devant chaque dispositif ou chaque installation.

Le dispositif de traitement thermique selon l'invention est de préférence situé juste après l'installation de dépôt du revêtement, par exemple à la sortie de l'installation de dépôt. Le substrat revêtu peut ainsi être traité en ligne après le dépôt du revêtement, à la sortie de l'installation de dépôt et avant les dispositifs de contrôle optique, ou après les dispositifs de contrôle optique et avant les dispositifs d'empilage des substrats.

Le dispositif de traitement thermique peut aussi être intégré à l'installation de dépôt. Par exemple, le laser peut être introduit dans une des chambres d'une installation de dépôt par pulvérisation cathodique, notamment dans une chambre où l'atmosphère est raréfiée, notamment sous une pression comprise entre 10⁻⁶ mbar et 10⁻² mbar. Le dispositif de traitement thermique peut aussi être disposé en dehors de l'installation de dépôt, mais de manière à traiter un substrat situé à l'intérieur de ladite installation. Il suffit de prévoir à cet effet un hublot transparent à la longueur d'onde du rayonnement utilisé, au travers duquel le rayonnement laser viendrait traiter la couche. Il est ainsi possible de traiter une couche (par exemple une couche d'argent) avant le dépôt subséquent d'une autre couche dans la même installation.

Que le dispositif de traitement thermique soit en dehors de ou intégré à l'installation de dépôt, ces procédés « en ligne » sont préférables à un procédé en reprise dans lequel il serait nécessaire d'empiler les substrats de verre entre l'étape de dépôt et le traitement thermique.

Les procédés en reprise peuvent toutefois avoir un intérêt dans les cas où la mise en oeuvre du traitement thermique selon l'invention est faite dans un lieu différent de celui où est réalisé le dépôt, par exemple dans un lieu où est réalisée la transformation du verre. Le dispositif de traitement thermique peut donc être intégré à d'autres lignes que la ligne de dépôt de couches. Il peut par exemple être intégré à une ligne de fabrication de vitrages multiples (doubles ou triples vitrages notamment), à une ligne de fabrication de vitrages feuilletés, ou encore à une ligne de fabrication de vitrages bombés et/ou trempés. Les vitrages feuilletés ou bombés ou trempés peuvent être utilisés aussi bien en tant que vitrages bâtiment ou automobile. Dans ces différents cas, le traitement thermique selon l'invention est de préférence réalisé avant la réalisation du vitrage multiple ou feuilleté. Le traitement thermique peut toutefois être mis en oeuvre après réalisation du double vitrage ou du vitrage feuilleté.

Le dispositif de traitement thermique est de préférence disposé dans une enceinte close permettant de sécuriser les personnes en évitant tout contact avec le rayonnement laser et d'éviter toute pollution, notamment du substrat, des optiques ou de la zone de traitement.

Le dépôt de l'empilement sur le substrat peut être réalisé par tout type de procédé, en particulier des procédés générant des couches majoritairement amorphes ou nano-cristallisées, tels que le procédé de pulvérisation cathodique, notamment assisté par champ magnétique (procédé magnétron), le procédé de dépôt chimique en phase vapeur assisté par plasma (PECVD), le procédé d'évaporation sous vide, ou le procédé sol-gel.

L'empilement est de préférence déposé par pulvérisation cathodique, notamment assistée par champ magnétique (procédé magnétron).

Pour plus de simplicité, le traitement thermique de l'empilement se fait de préférence sous air et/ou à pression atmosphérique. Il est toutefois possible de procéder au traitement thermique de l'empilement au sein même de l'enceinte de dépôt sous vide, par exemple avant un dépôt subséquent.

Le substrat est de préférence en verre ou en matière organique polymérique. Il est de préférence transparent, incolore (il s'agit alors d'un verre clair ou extra-clair) ou coloré, par exemple en bleu, gris, vert ou bronze. Le verre est de préférence de type silico-sodo-calcique, mais il peut également être en verre de type borosilicate ou alumino-borosilicate. Les matières organiques polymériques préférées sont le polycarbonate, le polyméthacrylate de méthyle, le polyéthylène téréphtalate (PET), le polyéthylène naphtalate (PEN), ou encore les polymères fluorés tels que l'éthylène tétrafluoroéthylène (ETFE). Le substrat présente avantageusement au moins une dimension supérieure ou égale à 1 m, voire 2 m et même 3 m. L'épaisseur du substrat varie généralement entre 0,5 mm et 19 mm, de préférence entre 0,7 et 9 mm, notamment entre 2 et 8 mm, voire entre 4 et 6 mm. Le substrat peut être plan ou bombé, voire flexible.

Le substrat de verre est de préférence du type flotté, c'est-à-dire susceptible d'avoir été obtenu par un procédé consistant à déverser le verre fondu sur un bain d'étain en fusion (bain « float »). Dans ce cas, le revêtement à traiter peut aussi bien être déposé sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre. Le substrat de verre peut également être obtenu par laminage entre deux rouleaux, technique permettant en particulier d'imprimer des motifs à la surface du verre.

Le traitement thermique est de préférence destiné à améliorer la cristallisation du revêtement, notamment par une augmentation de la taille des cristaux et/ou de la quantité de phase cristalline. Le traitement thermique peut également être destiné à oxyder une couche d'un métal ou d'un oxyde métallique sous-stoechiométrique en oxygène, éventuellement en favorisant la croissance d'une phase cristalline particulière.

De préférence, l'étape de traitement thermique ne met pas en oeuvre de fusion, même partielle, du revêtement. Dans les cas où le traitement est destiné à améliorer la cristallisation du revêtement, le traitement thermique permet d'apporter une énergie suffisante pour favoriser la cristallisation du revêtement par un mécanisme physico-chimique de croissance cristalline autour de germes déjà présents dans le revêtement, en restant en phase solide. Ce traitement ne met pas en oeuvre de mécanisme de cristallisation par refroidissement à partir d'un matériau fondu, d'une part car cela nécessiterait des températures extrêmement élevées, et d'autre part car cela serait susceptible de modifier les épaisseurs ou les indices de réfraction du revêtement, et donc ses propriétés, en modifiant par exemple son aspect optique.

Le revêtement traité comprend de préférence une couche mince choisie parmi les couches métalliques (notamment à base ou constituées d'argent ou de molybdène), les couches d'oxyde de titane et les couches transparentes électroconductrices.

Les couches transparentes électroconductrices sont typiquement à base d'oxydes mixtes d'étain et d'indium (appelées « ITO »), à base d'oxydes mixtes d'indium et de zinc (appelées « IZO »), à base d'oxyde de zinc dopé au gallium ou à l'aluminium, à base d'oxyde de titane dopé au niobium, à base de stannate de cadmium ou de zinc, à base d'oxyde d'étain dopé au fluor et/ou à l'antimoine. Ces différentes couches ont la particularité d'être des couches transparentes et néanmoins conductrices ou semiconductrices, et sont employées dans de nombreux systèmes où ces deux propriétés sont nécessaires : écrans à cristaux liquides (LCD), capteurs solaires ou photovoltaïques, dispositifs électrochromes ou électroluminescents (notamment LED, OLED)... Leur épaisseur, généralement pilotée par la résistance carrée désirée, est typiquement comprise entre 50 et 1000 nm, bornes comprises.

Les couches minces métalliques, par exemple à base d'argent métallique, mais aussi à base de molybdène ou de niobium métalliques, ont des propriétés de conduction électrique et de réflexion des rayonnements infrarouges, d'où leur utilisation dans des vitrages à contrôle solaire, notamment anti-solaires (visant à diminuer la quantité d'énergie solaire entrante) ou à faible émissivité (visant à diminuer la quantité d'énergie dissipée vers l'extérieur d'un bâtiment ou d'un véhicule). Leur épaisseur physique est typiquement comprise entre 4 et 20 nm (bornes comprises). Les empilements bas émissifs peuvent fréquemment comprendre plusieurs couches d'argent, typiquement 2 ou 3. La ou chaque couche d'argent est généralement entourée de couches diélectriques la protégeant de la corrosion et permettant d'ajuster l'aspect en réflexion du revêtement. Le molybdène est fréquemment employé comme matériau d'électrodes pour les cellules photovoltaïques à base de CuInₓGa₁₋ₓSe₂, où x varie de 0 à 1. Le traitement selon l'invention permet de réduire sa résistivité. D'autres métaux peuvent être traités selon l'invention, comme par exemple le titane, dans le but notamment de l'oxyder et d'obtenir une couche d'oxyde de titane photocatalytique.

Lorsque le revêtement à traiter est un empilement bas-émissif, il comprend de préférence, à partir du substrat, un premier revêtement comprenant au moins une première couche diélectrique, au moins une couche d'argent, éventuellement une couche de sur-bloqueur et un deuxième revêtement comprenant au moins une deuxième couche diélectrique.

De préférence, l'épaisseur physique de la ou de chaque couche d'argent est comprise entre 6 et 20 nm.

La couche de sur-bloqueur est destinée à protéger la couche d'argent pendant le dépôt d'une couche ultérieure (par exemple si cette dernière est déposée sous atmosphère oxydante ou nitrurante) et pendant un éventuel traitement thermique du type trempe ou bombage.

La couche d'argent peut également être déposée sur et en contact avec une couche de sous-bloqueur. L'empilement peut donc comprendre une couche de sur-bloqueur et/ou une couche de sous-bloqueur encadrant la ou chaque couche d'argent.

Les couches de bloqueur (sous-bloqueur et/ou sur-bloqueur) sont généralement à base d'un métal choisi parmi le nickel, le chrome, le titane, le niobium, ou d'un alliage de ces différents métaux. On peut notamment citer les alliages nickel-titane (notamment ceux comprenant environ 50% en poids de chaque métal) ou les alliages nickel-chrome (notamment ceux comprenant 80% en poids de nickel et 20% en poids de chrome). La couche de sur-bloqueur peut encore être constituée de plusieurs couches superposées, par exemple, en s'éloignant du substrat, de titane puis d'un alliage de nickel (notamment un alliage nickel-chrome) ou l'inverse. Les différents métaux ou alliages cités peuvent également être partiellement oxydés, notamment présenter une sous-stoechiométrie en oxygène (par exemple TiOₓ ou NiCrOₓ).

Ces couches de bloqueur (sous-bloqueur et/ou sur-bloqueur) sont très fines, normalement d'une épaisseur inférieure à 1 nm, pour ne pas affecter la transmission lumineuse de l'empilement, et sont susceptibles d'être partiellement oxydées pendant le traitement thermique selon l'invention. D'une manière générale les couches de bloqueur sont des couches sacrificielles, susceptibles de capter l'oxygène provenant de l'atmosphère ou du substrat, évitant ainsi l'oxydation de la couche d'argent.

La première et/ou la deuxième couche diélectrique est typiquement en oxyde (notamment en oxyde d'étain), ou de préférence en nitrure, notamment en nitrure de silicium (en particulier pour la deuxième couche diélectrique, la plus éloignée du substrat). D'une manière générale, le nitrure de silicium peut être dopé, par exemple avec de l'aluminium ou du bore, afin de faciliter son dépôt par les techniques de pulvérisation cathodique. Le taux de dopage (correspondant au pourcentage atomique par rapport à la quantité de silicium) ne dépasse généralement pas 2%. Ces couches diélectriques ont pour fonction de protéger la couche d'argent des agressions chimiques ou mécaniques et influent également sur les propriétés optiques, notamment en réflexion, de l'empilement, grâce à des phénomènes interférentiels.

Le premier revêtement peut comprendre une couche diélectrique, ou plusieurs couches diélectriques, typiquement 2 à 4. Le deuxième revêtement peut comprendre une couche diélectrique, ou plusieurs couches diélectriques, typiquement 2 à 3. Ces couches diélectriques sont de préférence en un matériau choisi parmi le nitrure de silicium, les oxydes de titane, d'étain ou de zinc, ou l'un quelconque de leurs mélanges ou solutions solides, par exemple un oxyde d'étain et de zinc, ou un oxyde de titane et de zinc. Que ce soit dans le premier revêtement ou dans le deuxième revêtement, l'épaisseur physique de la couche diélectrique, ou l'épaisseur physique globale de l'ensemble des couches diélectriques, est de préférence comprise entre 15 et 60 nm, notamment entre 20 et 50 nm.

Le premier revêtement comprend de préférence, immédiatement sous la couche d'argent ou sous l'éventuelle couche de sous-bloqueur, une couche de mouillage dont la fonction est d'augmenter le mouillage et l'accrochage de la couche d'argent. L'oxyde de zinc, notamment dopé à l'aluminium, s'est révélé particulièrement avantageux à cet égard.

Le premier revêtement peut également contenir, directement sous la couche de mouillage, une couche de lissage, qui est un oxyde mixte partiellement voire totalement amorphe (donc de très faible rugosité), dont la fonction est de favoriser la croissance de la couche de mouillage selon une orientation cristallographique préférentielle, laquelle favorise la cristallisation de l'argent par des phénomènes d'épitaxie. La couche de lissage est de préférence composée d'un oxyde mixte d'au moins deux métaux choisis parmi Sn, Zn, In, Ga, Sb. Un oxyde préféré est l'oxyde d'étain et d'indium dopé à l'antimoine.

Dans le premier revêtement, la couche de mouillage ou l'éventuelle couche de lissage est de préférence déposée directement sur la première couche diélectrique. La première couche diélectrique est de préférence déposée directement sur le substrat. Pour adapter au mieux les propriétés optiques de l'empilement (notamment l'aspect en réflexion), la première couche diélectrique peut alternativement être déposée sur une autre couche en oxyde ou en nitrure, par exemple en oxyde de titane.

Au sein du deuxième revêtement, la deuxième couche diélectrique peut être déposée directement sur la couche d'argent, ou de préférence sur un sur-bloqueur, ou encore sur d'autres couches en oxyde ou en nitrure, destinées à adapter les propriétés optiques de l'empilement. Par exemple, une couche d'oxyde de zinc, notamment dopé à l'aluminium, ou encore une couche d'oxyde d'étain, peut être disposée entre un sur-bloqueur et la deuxième couche diélectrique, qui est de préférence en nitrure de silicium. L'oxyde de zinc, notamment dopé à l'aluminium, permet d'améliorer l'adhésion entre l'argent et les couches supérieures.

Ainsi, l'empilement traité selon l'invention comprend de préférence au moins une succession ZnO / Ag / ZnO. L'oxyde de zinc peut être dopé à l'aluminium. Une couche de sous-bloqueur peut être disposée entre la couche d'argent et la couche sous-jacente. Alternativement ou cumulativement, une couche de sur-bloqueur peut être disposée entre la couche d'argent et la couche sus-jacente.

Enfin, le deuxième revêtement peut être surmonté d'une surcouche, parfois appelée « overcoat » dans la technique. Dernière couche de l'empilement, donc en contact avec l'air ambiant, elle est destinée à protéger l'empilement contre toutes agressions mécaniques (rayures...) ou chimiques. Cette surcouche est généralement très fine pour ne pas perturber l'aspect en réflexion de l'empilement (son épaisseur est typiquement comprise entre 1 et 5 nm). Elle est de préférence à base d'oxyde de titane ou d'oxyde mixte d'étain et de zinc, notamment dopé à l'antimoine, déposé sous forme sous-stoechiométrique.

L'empilement peut comprendre une ou plusieurs couches d'argent, notamment deux ou trois couches d'argent. Lorsque plusieurs couches d'argent sont présentes, l'architecture générale présentée ci-avant peut être répétée. Dans ce cas, le deuxième revêtement relatif à une couche d'argent donnée (donc situé au-dessus de cette couche d'argent) coïncide généralement avec le premier revêtement relatif à la couche d'argent suivante.

Les couches minces à base d'oxyde de titane ont la particularité d'être autonettoyantes, en facilitant la dégradation des composés organiques sous l'action de rayonnements ultraviolets et l'élimination des salissures minérales (poussières) sous l'action d'un ruissellement d'eau. Leur épaisseur physique est de préférence comprise entre 2 et 50 nm, notamment entre 5 et 20 nm, bornes comprises.

Les différentes couches citées présentent la particularité commune de voir certaines de leurs propriétés améliorées lorsqu'elles sont dans un état au moins partiellement cristallisé. On cherche généralement à augmenter au maximum le taux de cristallisation de ces couches (la proportion massique ou volumique de matière cristallisée) et la taille des grains cristallins (ou la taille de domaines cohérents de diffraction mesurés par des méthodes de diffraction des rayons X), voire dans certains cas à favoriser une forme cristallographique particulière.

Dans le cas de l'oxyde de titane, il est connu que l'oxyde de titane cristallisé sous la forme anatase est bien plus efficace en terme de dégradation des composés organiques que l'oxyde de titane amorphe ou cristallisé sous la forme rutile ou brookite.

Il est également connu que les couches d'argent présentant un taux de cristallisation élevé et par conséquent une faible teneur résiduelle en argent amorphe présentent une émissivité et une résistivité plus basses que des couches d'argent majoritairement amorphes. La conductivité électrique et les propriétés de faible émissivité de ces couches sont ainsi améliorées.

De même, les couches transparentes conductrices précitées, notamment celles à base d'oxyde de zinc dopé, d'oxyde d'étain dopé au fluor ou d'oxyde d'indium dopé à l'étain présentent une conductivité électrique d'autant plus forte que leur taux de cristallisation est élevé.

De préférence, lorsque le revêtement est conducteur, sa résistance carrée est diminuée d'au moins 10%, voire 15% ou même 20% par le traitement thermique. Il s'agit ici d'une diminution relative, par rapport à la valeur de la résistance carrée avant traitement.

D'autres revêtements peuvent être traités selon l'invention. On peut notamment citer, de manière non limitative, les revêtements à base de (ou constitués de) CdTe ou de chalcopyrites, par exemple du type CuInₓGa₁₋ₓSe₂, où x varie de 0 à 1. On peut également citer les revêtements de type émail (par exemple déposé par sérigraphie), peinture ou laque (typiquement comprenant une résine organique et des pigments).

Les substrats revêtus obtenus selon l'invention peuvent être utilisés dans des vitrages simples, multiples ou feuilletés, des miroirs, des revêtements muraux en verre. Si le revêtement est un empilement bas émissif, et dans le cas d'un vitrage multiple comportant au moins deux feuilles de verre séparées par une lame de gaz, il est préférable que l'empilement soit disposé sur la face en contact avec ladite lame de gaz, notamment en face 2 par rapport à l'extérieur (c'est-à-dire sur la face du substrat en contact avec l'extérieur du bâtiment qui est en opposée à la face tournée vers l'extérieur) ou en face 3 (c'est-à-dire sur la face du deuxième substrat en partant de l'extérieur du bâtiment tournée vers l'extérieur). Si le revêtement est une couche photocatalytique, il est de préférence disposé en face 1, donc en contact avec l'extérieur du bâtiment.

Les substrats revêtus obtenus selon l'invention peuvent aussi être utilisés dans des cellules ou vitrages photovoltaïques ou des panneaux solaires, le revêtement traité selon l'invention étant par exemple une électrode à base de ZnO : Al ou Ga dans des empilements à base de chalcopyrites (notamment du type CIGS - CuInₓGa₁₋ₓSe₂, x variant de 0 à 1) ou à base de silicium amorphe et/ou polycristallin, ou encore à base de CdTe.

Les substrats revêtus obtenus selon l'invention peuvent encore être utilisés dans des écrans de visualisation du type LCD (Liquid Crystal Display), OLED (Organic Light Emitting Diodes) ou FED (Field Emission Display), le revêtement traité selon l'invention étant par exemple une couche électroconductrice en ITO. Ils peuvent encore être utilisés dans des vitrages électrochromes, la couche mince traitée selon l'invention étant par exemple une couche électroconductrice transparente tel qu'enseignée dans la demande FR-A-2 833 107.

L'invention est illustrée à l'aide des exemples de réalisation non limitatifs qui suivent.

### EXEMPLE 1

On dépose par pulvérisation cathodique magnétron sur un substrat de verre clair dont la surface est de 600x3210 cm² et l'épaisseur de 4 mm un empilement bas-émissif contenant une couche d'argent.

Le tableau 1 ci-après indique l'épaisseur physique de chacune des couches de l'empilement, exprimée en nm. La première ligne correspond à la couche la plus éloignée du substrat, en contact avec l'air libre.

**Tableau 1**

| ZnSnSbOₓ | 2 |
|---|---|
| Si₃N₄ : Al | 43 |
| ZnO :Al | 5 |
| Ti | 0,5 |
| Ag | 15 |
| ZnO :Al | 5 |
| TiO₂ | 11 |
| Si₃N₄ :Al | 14 |

Le tableau 2 ci-après récapitule les paramètres du dépôt employés pour les différentes couches.

**Tableau 2**

| Couche | Cible employée | Pression de dépôt | Gaz |
|---|---|---|---|
| Si₃N₄ | Si:Al à 92:8 % wt | 1,5.10⁻³ mbar | Ar / (Ar + N₂) à 45 % |
| TiO₂ | TiOₓ avec x de l'ordre de 1,9 | 1,5.10⁻³ mbar | Ar / (Ar + O₂) à 95 % |
| ZnSnSbOₓ | SnZn:Sb à 34:65:1 wt | 2.10⁻³ mbar | Ar / (Ar + O₂) à 58 % |
| ZnO :Al | Zn:Al à 98:2 % wt | 2.10⁻³ mbar | Ar / (Ar + O₂) à 52 % |
| Ti | Ti | 2.10⁻³ mbar | Ar |
| Ag | Ag | 2.10⁻³ mbar | Ar à 100 % |

Le substrat est ensuite traité thermiquement à l'aide de onze lignes laser de 30 cm de longueur, disposées de sorte que toute la largeur du substrat soit traitée. Les sources laser sont des diodes laser émettant un rayonnement continu dont la longueur d'onde est de 915 nm ou 980 nm, sous forme de ligne focalisée sur le revêtement.

Le substrat revêtu de son empilement est disposé sur un convoyeur à rouleaux, au niveau du plan focal de chaque ligne laser, et vient défiler sous chaque ligne laser à une vitesse de 5 m/min, la vitesse ne variant pas de plus de 1% en relatif.

En fonctionnement, la puissance linéique de chaque ligne laser de 400 W/cm, la largeur moyenne de chaque ligne est de 53 micromètres, et le facteur de qualité du faisceau (beam parameter product) est de 2,5 mm.mrad.

De la sorte, la largeur de chaque ligne laser varie d'au plus 10% en relatif lorsque la distance du revêtement au plan focal du laser varie de +/- 0,5 mm.

En outre, la largeur de chaque ligne est homogène sur la longueur de chacune des lignes, de sorte que pour chaque ligne, la différence entre la largeur la plus grande et la largeur la plus petite vaut 3% de la valeur moyenne (soit 1,5 micromètres).

Le revêtement est traité de manière très homogène, la résistance carrée du revêtement diminuant de 18 à 21% en relatif en tout point du revêtement, sans génération de défauts optiques.

### EXEMPLE 2

Cet exemple se distingue de l'exemple 1 en ce que l'on utilise quinze lignes laser de 22 cm de longueur, juxtaposées de manière à former une ligne unique de 3,3 m de longueur. La puissance linéique de chaque ligne laser est de 500 W/cm, la largeur moyenne de chaque ligne de 50 micromètres, et le facteur de qualité du faisceau de 1,1 mm.mrad. De la sorte, la largeur de chaque ligne laser varie d'au plus 10% en relatif lorsque la distance du revêtement au plan focal du laser varie de +/- 1 mm. Le traitement est ici encore très homogène, le revêtement ne présentant aucun défaut optique.

### EXEMPLE COMPARATIF 1

Cet exemple comparatif se distingue de l'exemple 1 en ce que le facteur de qualité du faisceau est de 6,2 mm.mrad.

Dans ce cas, la largeur de chaque ligne laser varie d'environ 50% en relatif lorsque la distance du revêtement au plan focal du laser varie de +/- 0,5 mm.

On observe après traitement que la perte de résistance carrée n'est pas homogène sur toute la surface du substrat. Si à certains endroits, elle atteint 20 à 21%, elle n'est que de 3% dans certaines zones du substrat du fait des variations de distance entre le substrat et le plan focal générés par les défauts de planéité du substrat et son convoyage à grande vitesse.

### EXEMPLE COMPARATIF 2

Cet exemple se distingue de l'exemple 2 en ce que le facteur de qualité du faisceau est de 4 mm.mrad.

Dans ce cas, la largeur de chaque ligne laser varie d'environ 90% en relatif lorsque la distance du revêtement au plan focal du laser varie de +/- 1 mm.

Comme pour l'exemple comparatif 1, la perte de résistance carrée n'est pas homogène.

### EXEMPLE COMPARATIF 3

Cet exemple se distingue de l'exemple 1 en ce que la puissance linéique est de 180 W/cm. Dans ce cas, la perte de résistance carrée due au traitement est trop faible car le revêtement n'atteint pas les températures adéquates permettant sa cristallisation.

Afin de pouvoir atteindre les températures voulues, il est nécessaire de réduire la largeur moyenne de chaque ligne à 11 micromètres. Dans ce cas toutefois, la largeur de chaque ligne laser varie d'un facteur 10 lorsque la distance du revêtement au plan focal du laser varie de +/-0,5 mm. Compte tenu des défauts de planéité du substrat de grande taille, de son convoyage, et des vibrations, le traitement n'est alors pas homogène, la perte de résistance carrée variant de manière importante en fonction des zones de la surface du substrat.

### EXEMPLE COMPARATIF 4

Cet exemple se distingue de l'exemple 2 en ce que la puissance linéique est de 180 W/cm. Dans ce cas encore, la perte de résistance carrée due au traitement est trop faible car le revêtement n'atteint pas les températures adéquates permettant sa cristallisation.

Afin de pouvoir atteindre les températures voulues, il est nécessaire de réduire la largeur moyenne de chaque ligne à 7 micromètres. Dans ce cas toutefois, la largeur de chaque ligne laser varie d'un facteur 22 lorsque la distance du revêtement au plan focal du laser varie de +/-1 mm. Compte tenu des défauts de planéité du substrat de grande taille, de son convoyage, et des vibrations, le traitement n'est alors pas homogène, la perte de résistance carrée variant de manière importante en fonction des zones de la surface du substrat.

### EXEMPLE COMPARATIF 5

Cet exemple se distingue de l'exemple 1 en ce que chaque ligne n'est pas homogène en termes de largeur. Si la largeur moyenne est toujours de 53 micromètres, la distribution de largeurs est telle que la différence entre la largeur la plus grande et la largeur la plus élevée vaut 13 micromètres, soit 25% de la valeur moyenne. Le traitement est alors hétérogène : la couche est localement dégradée du fait d'une surintensité du traitement laser (dans les zones où la largeur de la ligne est plus faible), entraînant à la fois l'apparition de défauts optiques ponctuels visuellement inacceptables, et une perte globale de résistance carrée de seulement 13 à 14% en relatif.

## Revendications

1. Procédé d'obtention d'un substrat en verre ou un substrat organique polymérique muni sur au moins une partie d'au moins une de ses faces d'un revêtement, comprenant une étape de dépôt dudit revêtement sur ledit substrat, puis une étape de traitement thermique dudit revêtement au moyen d'un rayonnement laser pulsé ou continu focalisé sur ledit revêtement sous la forme d'au moins une ligne laser, dont la longueur d'onde est comprise dans un domaine allant de 400 à 1500 nm, ledit traitement thermique étant tel que l'on crée un mouvement de déplacement relatif entre le substrat et la ou chaque ligne laser dont la vitesse est d'au moins 3 mètres par minute, la ou chaque ligne laser présentant un facteur de qualité du faisceau (BPP) d'au plus 3 mm.mrad et, mesurées à l'endroit où la ou chaque ligne laser est focalisée sur ledit revêtement, une puissance linéique divisée par la racine carrée du rapport cyclique d'au moins 200 W/cm, une longueur d'au moins 20 mm et une distribution de largeurs le long de la ou chaque ligne telle que la largeur moyenne est d'au moins 30 micromètres et la différence entre la largeur la plus grande et la largeur la plus petite vaut au plus 15% de la valeur de la largeur moyenne.

2. Procédé selon la revendication 1, tel que le substrat est sensiblement horizontal et se déplace sur un convoyeur en regard de la ou chaque ligne laser, la ou chaque ligne laser étant fixe et disposée sensiblement perpendiculairement à la direction du déplacement.

3. Procédé selon l'une des revendications précédentes, tel que la longueur d'onde du rayonnement de la ou chaque ligne laser est comprise dans un domaine allant de 800 à 1100 nm.

4. Procédé selon l'une des revendications précédentes, tel que le rayonnement laser est continu.

5. Procédé selon l'une des revendications précédentes, tel que la puissance linéique divisée par la racine carrée du rapport cyclique est d'au moins 400 W/cm.

6. Procédé selon l'une des revendications précédentes, tel que la largeur moyenne de la ou chaque ligne laser est d'au moins 35 micromètres, notamment comprise dans un domaine allant de 40 à 70 micromètres.

7. Procédé selon l'une des revendications précédentes, tel que la longueur de la ou chaque ligne laser est d'au moins 20 cm, notamment comprise dans un domaine allant de 30 à 60 cm.

8. Procédé selon l'une des revendications précédentes, tel que la densité d'énergie fournie au revêtement divisée par la racine carrée du rapport cyclique est d'au moins 20 J/cm².

9. Procédé selon l'une des revendications précédentes, tel que le substrat (1) est en verre ou en matière organique polymérique.

10. Procédé selon l'une des revendications précédentes, tel que le substrat présente au moins une dimension supérieure à 1 m, notamment à 3 m.

11. Procédé selon l'une des revendications précédentes, tel que le revêtement (2) comprend au moins une couche mince choisie parmi les couches métalliques, notamment à base d'argent ou de molybdène, les couches d'oxyde de titane et les couches transparentes électroconductrices.

12. Procédé selon l'une des revendications précédentes, tel que la température subie par le revêtement lors du traitement thermique est d'au moins 300°C, notamment 400°C.

13. Procédé selon l'une des revendications précédentes, tel que la température de la face du substrat opposée à la face traitée par le au moins un rayonnement laser n'excède pas 100°C, notamment 50°C et même 30°C pendant le traitement thermique.

14. Dispositif de traitement thermique d'un revêtement déposé sur un substrat, en verre ou un substrat organique polymérique au moyen d'un rayonnement laser pulsé ou continu dont la longueur d'onde est comprise dans un domaine allant de 400 à 1500 nm, focalisé sur ledit revêtement sous la forme d'au moins une ligne, comprenant :
- une ou plusieurs sources laser ainsi que des optiques de mise en forme et de redirection capables de générer au moins une ligne laser susceptible de présenter en fonctionnement un facteur de qualité du faisceau (BPP) d'au plus 3 mm.mrad et, mesurées à l'endroit où la ou chaque ligne laser est focalisée sur ledit revêtement, une puissance linéique divisée par la racine carrée du rapport cyclique d'au moins 200 W/cm, une longueur d'au moins 20 mm et une distribution de largeurs le long de la ou chaque ligne telle que la largeur moyenne est d'au moins 30 micromètres et la différence entre la largeur la plus grande et la largeur la plus petite vaut au plus 15% de la valeur de la largeur moyenne, et
- des moyens de déplacement aptes à créer en fonctionnement un mouvement de déplacement relatif entre le substrat et la ou chaque ligne laser dont la vitesse est d'au moins 3 mètres par minute.

## Patentansprüche

1. Verfahren zum Erhalten eines Glassubstrats oder eines Substrats aus einem organischen Polymer, das auf mindestens einem Teil von mindestens einer seiner Flächen mit einer Beschichtung versehen ist, umfassend einen Schritt, in dem man die Beschichtung auf das Substrat aufbringt, dann einen Schritt der thermischen Behandlung der Beschichtung mithilfe einer gepulsten oder kontinuierlichen, auf die Beschichtung in Form von mindestens einer Laserlinie fokussierten Laserstrahlung, deren Wellenlänge im Bereich von 400 bis 1500 nm liegt, wobei die thermische Behandlung derart erfolgt, dass man eine relative Verschiebungsbewegung zwischen dem Substrat und der oder jeder Laserlinie erzeugt, deren Geschwindigkeit mindestens 3 Meter pro Minute beträgt, wobei die oder jede Laserlinie ein Strahlparameterprodukt (SPP) von höchstens 3 mm.mrad, gemessen an der Stelle, an der die oder jede Laserlinie auf die Beschichtung fokussiert ist, eine lineare Leistungsdichte, dividiert durch die Quadratwurzel des Arbeitszyklus, von mindestens 200 W/cm, eine Länge von mindestens 20 mm und eine derartige Verteilung der Breiten entlang der oder jeder Laserlinie, dass die mittlere Breite mindestens 30 Mikrometer beträgt und der Unterschied zwischen der größten Breite und der kleinsten Breite höchstens 15% des Wertes der mittleren Breite beträgt, aufweist.

2. Verfahren nach Anspruch 1, wobei das Substrat im Wesentlichen horizontal ist und sich auf einem Fördermittel gegenüber der oder jeder Laserlinie verschiebt, wobei die oder jede Laserlinie im Wesentlichen senkrecht zu der Richtung der Verschiebung fixiert und positioniert ist.

3. Verfahren nach einem der vorhergehenden Ansprüche, wobei die Wellenlänge der Strahlung der oder jeder Laserlinie in einem Bereich von 800 bis 1100 nm liegt.

4. Verfahren nach einem der vorhergehenden Ansprüche, wobei die Laserstrahlung kontinuierlich ist.

5. Verfahren nach einem der vorhergehenden Ansprüche, wobei die lineare Leistungsdichte, dividiert durch die Quadratwurzel des Arbeitszyklus, mindestens 400 W/cm beträgt.

6. Verfahren nach einem der vorhergehenden Ansprüche, wobei die mittlere Breite der oder jeder Laserlinie mindestens 35 Mikrometer beträgt, insbesondere in einem Bereich von 40 bis 70 Mikrometer liegt.

7. Verfahren nach einem der vorhergehenden Ansprüche, wobei die Länge der oder jeder Laserlinie mindestens 20 cm beträgt, insbesondere in einem Bereich von 30 bis 60 cm liegt.

8. Verfahren nach einem der vorhergehenden Ansprüche, wobei die der Beschichtung zugeführte Energiedichte, dividiert durch die Quadratwurzel des Arbeitszyklus, mindestens 20 J/cm² beträgt.

9. Verfahren nach einem der vorhergehenden Ansprüche, wobei das Substrat (1) aus Glas oder einem polymeren organischen Material ist.

10. Verfahren nach einem der vorhergehenden Ansprüche, wobei das Substrat mindestens eine Abmessung aufweist, die größer als 1 m, insbesondere größer als 3 m ist.

11. Verfahren nach einem der vorhergehenden Ansprüche, wobei die Beschichtung (2) mindestens eine Dünnschicht umfasst, die aus Metallschichten, insbesondere auf der Basis von Silber oder Molybdän, Titanoxidschichten und transparenten elektrisch leitenden Schichten ausgewählt ist.

12. Verfahren nach einem der vorhergehenden Ansprüche, wobei die Temperatur, der die Beschichtung bei der thermischen Behandlung unterliegt, mindestens 300°C, insbesondere 400°C beträgt.

13. Verfahren nach einem der vorhergehenden Ansprüche, wobei die Temperatur der Fläche des Substrats, die der Fläche gegenüberliegt, die durch die mindestens eine Laserstrahlung behandelt wird, während der thermischen Behandlung 100°C, insbesondere 50°C und sogar 30°C nicht übersteigt.

14. Vorrichtung zur thermischen Behandlung einer Beschichtung, die auf ein Glassubstrat oder ein Substrats aus einem organischen Polymer aufgebracht ist, mithilfe einer gepulsten oder kontinuierlichen Laserstrahlung, deren Wellenlänge in einem Bereich von 400 bis 1500 nm liegt, die auf die Beschichtung in Form mindestens einer Linie fokussiert ist, umfassend:
- eine oder mehrere Laserquelle(n) sowie eine Optik zur Formgestaltung und Umleitung, die mindestens eine Laserlinie erzeugen können, die im Betrieb ein Strahlparameterprodukt (SPP) von höchstens 3 mm.mrad, gemessen an der Stelle, an der die oder jede Laserlinie auf die Beschichtung fokussiert ist, eine lineare Leistungsdichte, dividiert durch die Quadratwurzel des Arbeitszyklus, von mindestens 200 W/cm, eine Länge von mindestens 20 mm und eine derartige Verteilung der Breiten entlang der oder jeder Laserlinie, dass die mittlere Breite mindestens 30 Mikrometer beträgt und der Unterschied zwischen der größten Breite und der kleinsten Breite höchstens 15% des Wertes der mittleren Breite beträgt, aufweist, und
- Verschiebungsmittel, die im Betrieb zwischen dem Substrat und der oder jeder Laserlinie eine relative Verschiebungsbewegung bewirken können, deren Geschwindigkeit mindestens 3 Meter pro Minute beträgt.

## Claims

1. A process for obtaining a glass substrate or a polymeric organic substrate provided on at least one portion of at least one of its sides with a coating, comprising a step of depositing said coating on said substrate, then a step of heat treatment of said coating using a pulsed or continuous laser radiation focused on said coating in the form of at least one laser line, the wavelength of which is within a range extending from 400 to 1500 nm, said heat treatment being such that a relative displacement movement is created between the substrate and the or each laser line, the speed of which is at least 3 meters per minute, the or each laser line having a beam parameter product (BPP) of at most 3 mm.mrad and, measured at the place where the or each laser line is focused on said coating, a linear power density divided by the square root of the duty cycle of at least 200 W/cm, a length of at least 20 mm and a width distribution along the or each line such that the mean width is at least 30 micrometers and the difference between the largest width and the smallest width is at most 15% of the value of the mean width.

2. The process as claimed in claim 1, such that the substrate is substantially horizontal and travels on a conveyor facing the or each laser line, the or each laser line being fixed and positioned substantially perpendicular to the direction of travel.

3. The process as claimed in either of the preceding claims, such that the wavelength of the radiation of the or each laser line is within a range extending from 800 to 1100 nm.

4. The process as claimed in one of the preceding claims, such that the laser radiation is continuous.

5. The process as claimed in one of the preceding claims, such that the linear power density divided by the square root of the duty cycle is at least 400 W/cm.

6. The process as claimed in one of the preceding claims, such that the mean width of the or each laser line is at least 35 micrometers, in particular within a range extending from 40 to 70 micrometers.

7. The process as claimed in one of the preceding claims, such that the length of the or each laser line is at least 20 cm, in particular within a range extending from 30 to 60 cm.

8. The process as claimed in one of the preceding claims, such that the energy density provided to the coating divided by the square root of the duty cycle is at least 20 J/cm².

9. The process as claimed in one of the preceding claims, such that the substrate (1) is made of glass or of a polymeric organic material.

10. The process as claimed in one of the preceding claims, such that the substrate has at least one dimension greater than 1 m, in particular greater than 3 m.

11. The process as claimed in one of the preceding claims, such that the coating (2) comprises at least one thin layer chosen from metallic layers, in particular based on silver or on molybdenum, titanium oxide layers and transparent electrically conductive layers.

12. The process as claimed in one of the preceding claims, such that the temperature to which the coating is subjected during the heat treatment is at least 300°C, in particular 400°C.

13. The process as claimed in one of the preceding claims, such that the temperature of the side of the substrate opposite the side treated by the at least one laser radiation does not exceed 100°C, in particular 50°C and even 30°C during the heat treatment.

14. A device for the heat treatment of a coating deposited on a glass substrate or a polymeric organic substrate, using a pulsed or continuous laser radiation, the wavelength of which is within a range extending from 400 to 1500 nm, focused on said coating in the form of at least one line, comprising:
- one or more laser sources and also forming and redirecting optics capable of generating at least one laser line able to exhibit, in operation, a beam parameter product (BPP) of at most 3 mm.mrad and, measured at the place where the or each laser line is focused on said coating, a linear power density divided by the square root of the duty cycle of at least 200 W/cm, a length of at least 20 mm and a width distribution along the or each line such that the mean width is at least 30 micrometers and the difference between the largest width and the smallest width is at most 15% of the value of the mean width, and
- displacement means capable of creating, in operation, a relative displacement movement between the substrate and the or each laser line, the speed of which is at least 3 meters per minute.
